# EUROPÄISCHE PATENTSCHRIFT

(11) **EP 3 733 453 B1**
(45) Veröffentlichungstag und Bekanntmachung des Hinweises auf die Patenterteilung: **10.04.2024**
(21) Anmeldenummer: 19172364.2
(22) Anmeldetag: 02.05.2019
(51) Int. Cl.: B60Q 1/26, F21S 43/14, F21S 43/20, F21S 43/31, B60Q 1/50, G09F 9/30, G09F 21/04, G09F 9/33, F21S 43/40, H01L 25/075, F21V 8/00, G02B 19/00, F21Y 105/10, H01L 33/58

(54) **FAHZEUGLEUCHTE MIT EINEM LEUCHTMITTEL**
VEHICLE LAMP COMPRISING A LIGHTING DEVICE
FEU DE VÉHICULE LE COMPRENANT UN MOYEN D'ÉCLAIRAGE

(43) Veröffentlichungstag der Anmeldung: 04.11.2020
(73) Patentinhaber: odelo GmbH, 70329 Stuttgart (DE)
(72) Erfinder: BISCH, Valentin, 70186 Stuttgart (DE)
(74) Vertreter: Benninger, Johannes

(56) Entgegenhaltungen:
- CN-A- 105 179 962
- DE-A1-102007 033 438
- DE-A1-102011 012 297
- DE-A1-102018 208 822
- GB-A- 2 554 103
- JP-A- H0 968 934
- US-A- 4 733 335
- US-A1- 2010 039 830
- US-A1- 2010 331 929

## Beschreibung

Die Erfindung betrifft eine mit einem Leuchtmittel ausgestattete Fahrzeugleuchte gemäß dem Oberbegriff des Anspruchs 1.

Eine Fahrzeugleuchte umfasst beispielsweise einen im Wesentlichen von einem Leuchtengehäuse und einer Lichtscheibe umschlossenen Leuchteninnenraum und mindestens ein darin beherbergtes, mindestens eine Lichtquelle umfassendes Leuchtmittel für wenigstens eine Lichtfunktion der Fahrzeugleuchte.

Die Lichtscheibe ist durch eine heutzutage meist aus einem Kunststoff hergestellte, transparente Abdeckung gebildet, welche den Leuchteninnenraum abschließt und die darin beherbergten Bauteile, wie etwa ein oder mehrere Leuchtmittel, Reflektoren sowie alternativ oder zusätzlich vorgesehene, das Licht der einzelnen Lichtfunktionen entsprechend einer vorgegebenen Lichtverteilung und/oder unter Beitrag zu einer solchen Lichtverteilung umlenkende und/oder streuende optische Elemente gegen Witterungseinflüsse schützt.

Beispiele für Fahrzeugleuchten sind am Fahrzeugbug, an den Fahrzeugflanken und/oder an den Seitenspiegeln sowie am Fahrzeugheck angeordnete Wiederholblinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine solche Kombination ist beispielsweise regelmäßig in den bekannten Heckleuchten verwirklicht. In diesen kommen beispielsweise Wiederholblinkleuchten, Begrenzungsleuchten, Bremsleuchten, Nebelleuchten sowie Rückfahrleuchten zum Einsatz, um nur eine von vielen in Heckleuchten verwirklichten Kombinationen zu nennen. Weder erhebt diese Aufzählung Anspruch auf Vollständigkeit, noch bedeutet dies, dass in einer Heckleuchte alle genannten Leuchten kombiniert werden müssen. So können beispielsweise auch nur zwei oder drei der genannten oder auch anderer Leuchten in einem gemeinsamen Leuchtengehäuse einer Heckleuchte miteinander kombiniert sein.

Das Leuchtengehäuse bzw. der Leuchteninnenraum kann in mehrere Kammern mit jeweils eigenen Lichtquellen und/oder Leuchtmitteln und/oder Optikelementen sowie gegebenenfalls Lichtscheiben unterteilt sein, von denen mehrere Kammern gleiche und/oder jede Kammer eine andere Lichtfunktionen erfüllen kann.

Jede Fahrzeugleuchte, insbesondere Automobilleuchte, erfüllt je nach Ausgestaltung eine oder mehrere Aufgaben bzw. Funktionen. Zur Erfüllung jeder Aufgabe bzw. Funktion ist eine Lichtfunktion der Fahrzeugleuchte vorgesehen. Lichtfunktionen sind beispielsweise bei einer Ausgestaltung als Scheinwerfer eine die Fahrbahn ausleuchtende Funktion, oder bei einer Ausgestaltung als Signalleuchte eine Signalfunktion, wie beispielsweise eine Wiederholblinklichtfunktion zur Fahrtrichtungsanzeige oder eine Bremslichtfunktion zur Anzeige einer Bremstätigkeit, oder z.B. einer Begrenzungslichtfunktion, wie etwa einer Rücklichtfunktion, zur Sicherstellung einer Sichtbarkeit des Fahrzeugs bei Tag und/oder Nacht, wie etwa bei einer Ausgestaltung als Heckleuchte oder Tagfahrleuchte.

Jede Lichtfunktion muss dabei eine beispielsweise gesetzlich vorgegebene Lichtverteilung erfüllen. Die Lichtverteilung legt dabei mindestens einzuhaltende, umgangssprachlich als Helligkeit bezeichnete Lichtströme in zumindest einzuhaltenden Raumwinkelbereichen fest.

Den einzelnen Lichtfunktionen sind zum Teil unterschiedliche Helligkeiten bzw. Sichtweiten sowie zum Teil unterschiedliche Lichtfarben zugeordnet.

Für einen von außerhalb einer Fahrzeugleuchte auf die Lichtscheibe blickenden Betrachter erscheinen die aktiven Lichtfunktionen als leuchtende Teilflächen einer Leuchtfläche.

Um die Verkehrssicherheit zu erhöhen, ist es erstrebenswert, die Wahrnehmbarkeit beziehungsweise Wahrnehmungskraft von Lichtfunktionen einer Fahrzeugleuchte für andere Verkehrsteilnehmer zu erhöhen.

Hierzu ist beispielsweise bekannt, einzelne Lichtfunktionen innerhalb der gesetzlich zugelassenen Grenzen aufleben zu lassen.

Ein bekanntes Beispiel sind so genannte dynamische Lichtfunktionen, bei denen die vom Gesetzgeber eingeräumte Zeit, die eine Glühlampe als eine gesetzlich erlaubte Lichtquelle eines zur Erfüllung einer Lichtfunktion vorgesehenen Leuchtmittels benötigt, um ihre volle Leuchtstärke zu erreichen, genutzt wird, um einen visuellen Effekt zu erzielen.

Ein Beispiel eines solchen visuellen Effekts ist das Wischen in Richtung einer beabsichtigten Fahrtrichtungsänderung bei einer durch mehrere nebeneinander angeordnete und individuell nacheinander der Reihe nach angehend ansteuerbare Halbleiterlichtquellen, wie etwa LEDs (anorganische Leuchtdioden) und/oder OLEDs (organische Leuchtdioden) und/oder Laserlichtquellen verwirklichten Wiederholblinklichtfunktion eines Fahrtrichtungsanzeigers.

Dabei werden innerhalb der ersten 200 ms des Aufleuchtens durch die individuell ansteuerbare Halbleiterlichtquellen gebildete einzelne Segmente einer der jeweiligen Lichtfunktion zugeordneten Teilfläche der Leuchtfläche von der Fahrzeugmitte Richtung außen nacheinander aktiviert, so dass optisch eine Wischbewegung beim Einschalten entsteht.

Die Halbleiterlichtquellen weisen eine sehr kurze, kaum messbare Aktivierungszeit vom Beginn einer Strombeaufschlagung bis zur Abstrahlung von Licht auf. Dabei erfolgt die Lichtabstrahlung im Gegensatz zu einer Glühlampe quasi vom ersten Augenblick der Strombeaufschlagung an mit voller, der Stromstärke proportionaler Leuchtstärke.

Um die Verkehrssicherheit zu erhöhen ist außerdem bekannt, den momentan benötigten Lichtfunktionen den größtmöglichen Teil der Leuchtfläche zur Verfügung zu stellen, wie dies beispielsweise bei der durch EP 2 503 222 A1 vorbekannten Fahrzeugleuchte mit zumindest zwei Lichtfunktionen und einem von einem Gehäuse und einer Lichtscheibe umschlossenen Leuchteninnenraum vorgesehen ist. Diese umfasst bekannt. Dieser beherbergt mindestens eine von außen durch die Lichtscheibe hindurch zumindest zum Teil sichtbare Projektionsfläche sowie mindestens ein Mittel zur variablen Projektion der momentan benötigten einen oder mehreren Lichtfunktionen der Fahrzeugleuchte zumindest auf den vollständigen, von außen durch die Lichtscheibe hindurch sichtbaren Teil der Projektionsfläche. Dabei kann die Projektionsfläche kann von einer durch ein hintergrundbeleuchtetes LCD-Display oder einen Bildschirm beispielsweise in OLED- oder LED-Technologie gebildeten Leuchtfläche umfasst sein. Insbesondere kann die Projektionsfläche von einer Leuchtfläche eines Leuchtmittels umfasst sein, dessen Lichtquelle das hintergrundbeleuchtete LCD-Display oder den beispielsweise in OLED- oder LED-Technologie verwirklichten Bildschirm umfasst.

Eine derart von einem Leuchtmittel umfasste Projektionsfläche kann die gesamte Leuchtfläche der Fahrzeugleuchte darstellen.

Darüber hinaus können zur Verwirklichung einer Lichtfunktion vorgesehene, in ihrer beispielsweise durch den äußeren Umriss gebildeten Geometrie individuell veränderbare Teilflächen der Leuchtfläche geeignet sein, die Wahrnehmbarkeit beziehungsweise Wahrnehmungskraft von Lichtfunktionen einer Fahrzeugleuchte für andere Verkehrsteilnehmer zu erhöhen.

Als Nebeneffekt können solche Lichtfunktionen auch zur Individualisierung von mit entsprechenden Fahrzeugleuchten ausgestatteten Fahrzeugen beitragen.

So kommen in der Automobilbeleuchtung vermehrt veränderbare Lichtsignaturen innerhalb einer Lichtfunktion zum Einsatz. Dabei handelt es sich beispielsweise um personalisierbare Schlusslichtfunktions-Signaturen, Mehrfach-Lichtfunktions-Signaturen, funktionale Darstellungen für Hinweise, beleuchtete und inszenierbare Herstellerlogos, etc..

Eine Verwirklichung der Zuteilung veränderlicher Leuchtflächenabmessungen zu den momentan benötigten Lichtfunktionen oder einer Individualisierung von Lichtfunktionen scheitert bislang hauptsächlich an der möglichen Lichtstärke verfügbarer Konzepte.

Hoch auflösende Leuchtflächen aus einer Vielzahl von Pixeln, wie sie beispielsweise von TVs bekannt sind, weisen eine nur ungenügende Lichtstärke auf, um in Fahrzeugleuchten eingesetzt werden zu können.

So sind freiprogrammierbare Display und/oder OLED-Lösungen für die Verwirklichung von Lichtfunktionen in Automobilanwendungen oft zu kostspielig und auch zu lichtschwach. Auch ist das hohe Auflösungsvermögen bei den typischen Betrachtungsabständen von Beleuchtungseinrichtungen nicht zwingend notwendig.

Ansätze für lichtstärkere Pixelfelder führen nicht zum gewünschten Ergebnis, da es z.B. zu einem Übersprechen zwischen den Pixeln kommt, oder die Pixel bei der Betrachtung nicht scharf genug voneinander getrennt scheinen.

Gelöst wurde dieses Problem bisher durch segmentierbare OLEDs, ein so genanntes Matrix-Schachtsystem, oder ein MikroLED-Array.

Segmentierbare OLEDs weisen die Nachteile einer aufgrund mangelnder Temperaturstabilität der für sie verwendeten organischen Werkstoffe nur eingeschränkten Lebensdauer, hoher Kosten, qualitativer Einschränkungen aufgrund nichtleuchtender Schablonierungsrahmen um die Segmente, sowie einer begrenzten Lichtintensität auf.

Das Matrix-Schachtsystem weist den wesentlichen Nachteil eines Bedarfs an sichtbaren Trennstegen von ca. 2mm zwischen den einzelnen Pixeln auf, was zu einem nicht präzisen Erscheinungsbild führt, weil die Gitterstruktur ist sowohl im Kaltdesign bei ausgeschaltetem Leuchtmittel als auch im Warmdesign bei eingeschaltetem Leuchtmittel erkennbar bleibt.

Das MikroLED-Array weist den entscheidenden Nachteil auf, dass es sehr teuer in der Herstellung und darüber hinaus noch nicht serientauglich ist. Darüber hinaus ist sein Erscheinungsbild nicht kompatibel mit bestehenden Konzepten.

Durch US 2010/0331929 A1 ist eine Vorrichtung zur Erzeugung einer gleichmäßigen Beleuchtung bekannt. Diese umfasst eine Kollimationseinrichtung mit einem Feld von Hohllichtleitern. Jeder Hollichtleiter weist eine Lichteintrittsfläche und eine gegenüberliegende Lichtaustrittsfläche auf. Die Hohllichtleiter liegen aneinander an. Jeder Hohllichtleiter beinhaltet mindestens eine Seitenwand, durch die wenigstens ein Lichtkorridor begrenzt ist. Die die Lichtkorridore begrenzenden Seitenwände sind reflektierend ausgebildet. Jedem der Lichtkorridore kann auf Seite der Lichteintrittsfläche eine LED zugeordnet sein.

Durch DE 10 2018 208 822 A1 ist eine Leuchtvorrichtung für ein Fahrzeug bekannt, bei der eine lichtstreuende Wirkung durch Vorsetzen eines Diffusors auf die Oberfläche eines Lichtleiters erhalten wird. Der Diffusor kann auf die Oberfläche des Lichtleiters aufgeklebt oder auf die Oberfläche des Lichtleiters aufgespritzt werden. Durch DE 10 2007 033438 A1 ist eine weitere Leuchtvorrichtung für ein Fahrzeug bekannt.

Eine Aufgabe der Erfindung ist es, ein kostengünstiges, lichtstarkes Leuchtmittel zu schaffen, mit einer für die Anwendung zur Verwirklichung von Lichtfunktionen einer Fahrzeugleuchte passenden Pixelgröße, einer hohen Homogenität und einem hohen Kontrastverhalten. Ebenfalls eine Aufgabe der Erfindung ist es, eine mit einem entsprechenden Leuchtmittel ausgestattete Fahrzeugleuchte zu schaffen.

Die Aufgabe wird durch die Merkmale des unabhängigen Anspruchs gelöst. Vorteilhafte Ausführungsformen sind in den Ansprüchen, den Zeichnungen sowie in der nachfolgenden Beschreibung, einschließlich der zu den Zeichnungen zugehörigen, wiedergegeben.

Die Erfindung betrifft demnach ein Leuchtmittel mit einer durch Lichtaustrittsflächen von Pixeln eines Pixelfelds gebildeten Leuchtfläche.

Jedes Pixel des Pixelfelds umfasst einen Optikkörper mit einer vorderseitigen Lichtaustrittsfläche und einer rückseitigen Lichteinkoppelfläche sowie einer die Lichteinkoppelfläche und die Lichtaustrittsfläche miteinander verbindenden Seitenfläche.

Zumindest die Seitenfläche ist verspiegelt, um ein Überkoppeln von Licht aus einem Pixel in ein benachbartes zu vermeiden.

Der Lichteinkoppelfläche jeden Optikkörpers ist mindestens eine individuell ansteuerbare LED als Lichtquelle zugeordnet, so dass jedes Pixel des Pixelfelds unabhängig von einem Nachbarpixelfeld ausleuchtbar ist.

Die Erfindung betrifft eine Fahrzeugleuchte mit einem von einem Leuchtengehäuse und einer zumindest für im für das menschliche Auge sichtbaren Teil des elektromagnetischen Spektrums liegendes Licht transparenten Lichtscheibe zumindest teilweise umschlossenen Leuchteninnenraum, der ein Leuchtmittel mit einer durch Lichtaustrittsflächen von Pixeln eines Pixelfelds gebildeten Leuchtfläche gemäß des ersten Gegenstands der Erfindung beherbergt.

Die Erfindung schlägt zur Lösung des bestehenden Problems demnach ein Pixelfeld aus makroskopischen Pixeln mit einer Kantenlänge von vorzugsweise ca. 3 mm bis 20 mm vor, von denen jedes durch einen Optikkörper gebildet ist, der einer LED vorgesetzt ist. Die Seitenflächen sowie gegebenenfalls weitere Teilflächen der Optikkörper sind mit einer Verspiegelung versehen, um ein Übersprechen zwischen benachbarten Pixeln zu vermeiden.

Die Pixel können orthogonal zueinander angeordnet sein, oder genestet.

Demnach können die einzelnen Pixel in der Draufsicht auf die durch das Pixelfeld gebildete Leuchtfläche eine rechteckige, insbesondere quadratische Geometrie aufweisen, oder sie können sechseckig ausgeführt sein. Auch eine runde Ausgestaltung ist denkbar. Ferner sind beispielsweise konvex-konkav ineinander übergehende Kombinationen verschiedener Geometrien der Lichtaustrittsflächen der Pixel innerhalb des Pixelfelds denkbar.

Um ein besonders homogenes Erscheinungsbild der Leuchtfläche zu gewährleisten besteht der Optikkörper aus einem volumenstreuenden Material.

Es ist ersichtlich, dass die Erfindung eine Leuchtfläche eines zur Erfüllung einer oder mehrerer Lichtfunktionen einer Fahrzeugleuchte vorgesehenen oder zumindest beitragenden Leuchtmittels umfasst, die aus den Auskoppelflächen eines Felds und/oder einer Vielzahl skalierbarer makroskopischer Pixel mit integrierter Lichtabschottung gebildet ist.

Die der Erfindung dabei zu Grunde liegende Hauptidee ist ein skalierbarer, makroskopischer Pixel mit einem Optikkörper, vorzugsweise mit einer Kantenlänge und/oder mit einer maximalen Abmessung seiner Lichtaustrittsfläche in einer Draufsicht von bevorzugt 3 mm bis 20 mm, besonders bevorzugt von 5 mm bis zu 16 mm, und mit einer Lichtabschottung zum Nachbarpixel mit einer Dickenabmessung im Nanometerbereich, beispielsweise realisiert über einen Metallisierungs-/Bedampfungsprozess. Der nachfolgend auch Optikkörper oder Optikelement genannte Pixel wird dabei durch eine konventionelle LED Lichtquelle betrieben. Dies ermöglicht je nach gewählter Lichtemissionsleistung der verwendeten LEDs nicht nur die Verwirklichung von Schlusslichtfunktionen, sondern auch die Verwirklichung lichtintensiverer Lichtfunktionen wie beispielsweise einer Bremslichtfunktion und/oder einer beispielsweise durch eine Wiederholblinklichtfunktion gebildeten F ah rtrichtungsanzeige.

Ein über die um mehrere Größenordnungen stärkere Lichtabstrahlung der erfindungsgemäßen Lösung hinausgehender Vorteil gegenüber dem Stand der Technik ist dabei die quasi nicht sichtbare Lichtabschottung zwischen den Pixeln. Dies ermöglicht sowohl homogen leuchtende Flächenbereiche mit mehreren aktiven Pixeln als auch scharf abgegrenzte, geometrische Formen zu nicht aktiven Pixeln. Dies führt zu einem präzisen und hochwertigen und gut erkenn- und/oder lesbaren Erscheinungsbild, da ein ungewolltes Glimmen oder Mitleuchten von Nachbarpixeln vermieden wird.

Dadurch, dass für das Pixelfeld nur Standardmaterialien, wie etwa volumenstreuender Kunststoff für die bevorzugt in Spritzgusstechnik hergestellten Optikkörper, standard Lichtquellen, wie etwa LEDs, und Standardprozesse, wie etwa einer Metallisierung von Kunststoffoberflächen zur Erzeugung der Lichtabschottung zwischen den Nachbarpixeln, verwendet werden, wird eine kostengünstige Umsetzung erhalten.

Die Fahrzeugleuchte kann einzelne oder eine Kombination der zuvor und/oder nachfolgend in Verbindung mit dem Leuchtmittel beschriebene Merkmale aufweisen, ebenso wie das Leuchtmittel einzelne oder eine Kombination mehrerer zuvor und/oder nachfolgend in Verbindung mit der Fahrzeugleuchte beschriebene Merkmale aufweisen und/oder verwirklichen kann.

Die Fahrzeugleuchte und/oder das Leuchtmittel können alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen.

Zusätzliche, über die vollständige Lösung der gestellten Aufgabe und/oder über die voran zu den einzelnen Merkmalen genannten Vorteile hinausgehende Vorteile gegenüber dem Stand der Technik sind ebenfalls nachfolgend aufgeführt.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar. Es zeigen in schematischer Darstellung:
- Fig. 1: ein Leuchtmittel mit einer durch Lichtaustrittsflächen der Optikkörper von Pixeln eines Pixelfelds gebildeten Leuchtfläche in einer einen eine auf der Leuchtfläche aufstehenden Flächennormale einschließenden Querschnitt durch zwei benachbarte Pixel hindurch zeigenden Ansicht.
- Fig. 2: ein Ausführungsbeispiel einer durch ein Pixelfeld mit 21 quadratischen Pixeln mit einer Kantenlänge von 16 mm gebildeten Leuchtfläche eines Leuchtmittels in einer Draufsicht.
- Fig. 3: ein Ausführungsbeispiel einer durch ein Pixelfeld mit 21 hexagonalen Pixeln mit einer Kantenlänge von 16 mm gebildeten Leuchtfläche eines Leuchtmittels in einer Draufsicht.
- Fig. 4: ein erstes Ausführungsbeispiel einer Lichtsignatur einer durch das Pixelfeld aus Fig. 3 verwirklichbaren Lichtfunktion in einer Draufsicht auf die Leuchtfläche, wobei bei dem Ausführungsbeispiel alle Pixel an sind und Licht abstrahlen.
- Fig. 5: ein zweites Ausführungsbeispiel einer Lichtsignatur einer durch das Pixelfeld aus Fig. 3 verwirklichbaren Lichtfunktion in einer Draufsicht auf die Leuchtfläche, wobei bei dem Ausführungsbeispiel nur ein Teil der Pixel an sind und Licht abstrahlen.
- Fig. 6: ein drittes Ausführungsbeispiel einer Lichtsignatur einer durch das Pixelfeld aus Fig. 3 verwirklichbaren Lichtfunktion in einer Draufsicht auf die Leuchtfläche, wobei bei dem Ausführungsbeispiel nur ein Teil der Pixel an sind und Licht abstrahlen.
- Fig. 7: ein viertes Ausführungsbeispiel einer Lichtsignatur einer durch das Pixelfeld aus Fig. 3 verwirklichbaren Lichtfunktion in einer Draufsicht auf die Leuchtfläche, wobei bei dem Ausführungsbeispiel nur ein Teil der Pixel an sind und Licht abstrahlen.
- Fig. 8: ein fünftes Ausführungsbeispiel einer eine nach außerhalb einer Fahrzeugleuchte erkennbare Zusatzinformation "HI" beispielsweise für einen Betriebszustand eines Fahrzeugs, beispielsweise einen hohen Emissionszustand beispielsweise eines Hybridfahrzeugs oder einen hohen Ladezustand eines Stromspeichers eines Elektrofahrzeugs wiedergebenden, hierdurch funktionalen Lichtsignatur einer durch das Pixelfeld aus Fig. 3 verwirklichbaren Lichtfunktion in einer Draufsicht auf die Leuchtfläche, wobei bei dem Ausführungsbeispiel nur ein Teil der Pixel an sind und Licht abstrahlen.
- Fig. 9: ein sechstes Ausführungsbeispiel einer eine nach außerhalb einer Fahrzeugleuchte erkennbare Zusatzinformation "LO" beispielsweise für einen Betriebszustand eines Fahrzeugs, beispielsweise einen niederen Emissionszustand beispielsweise eines Hybridfahrzeugs oder einen niederen Ladezustand eines Stromspeichers eines Elektrofahrzeugs wiedergebenden, hierdurch funktionalen Lichtsignatur einer durch das Pixelfeld aus Fig. 3 verwirklichbaren Lichtfunktion in einer Draufsicht auf die Leuchtfläche, wobei bei dem Ausführungsbeispiel nur ein Teil der Pixel an sind und Licht abstrahlen.
- Fig. 10: ein siebtes Ausführungsbeispiel einer eine nach außerhalb einer Fahrzeugleuchte erkennbare Zusatzinformation "TT" beispielsweise für einen Betriebs- oder Wartungszustand eines Fahrzeugs wiedergebenden, hierdurch funktionalen Lichtsignatur einer durch das Pixelfeld aus Fig. 3 verwirklichbaren Lichtfunktion in einer Draufsicht auf die Leuchtfläche, wobei bei dem Ausführungsbeispiel nur ein Teil der Pixel an sind und Licht abstrahlen.

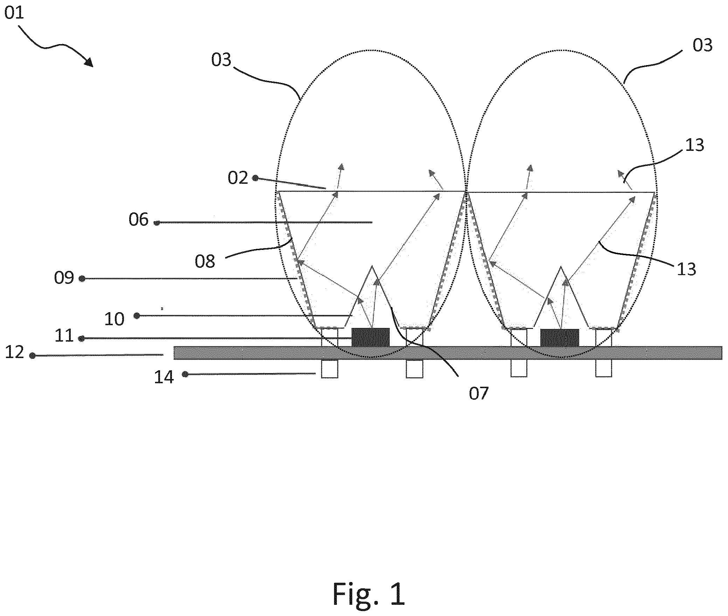

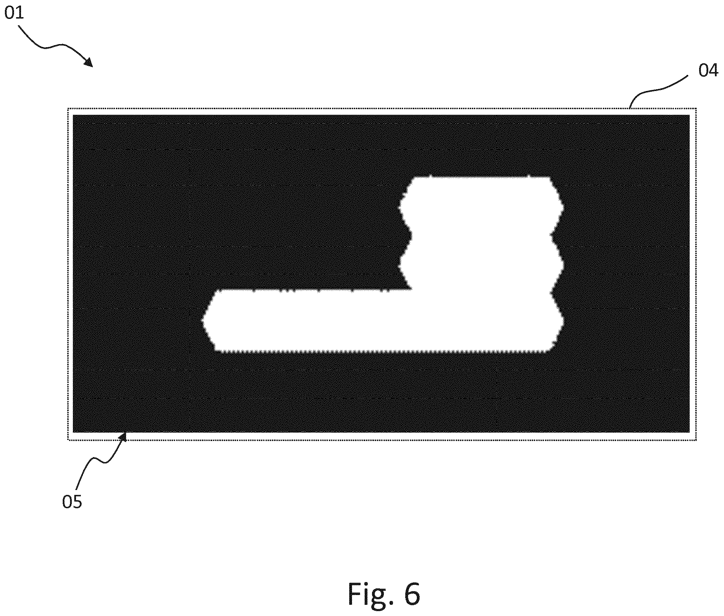

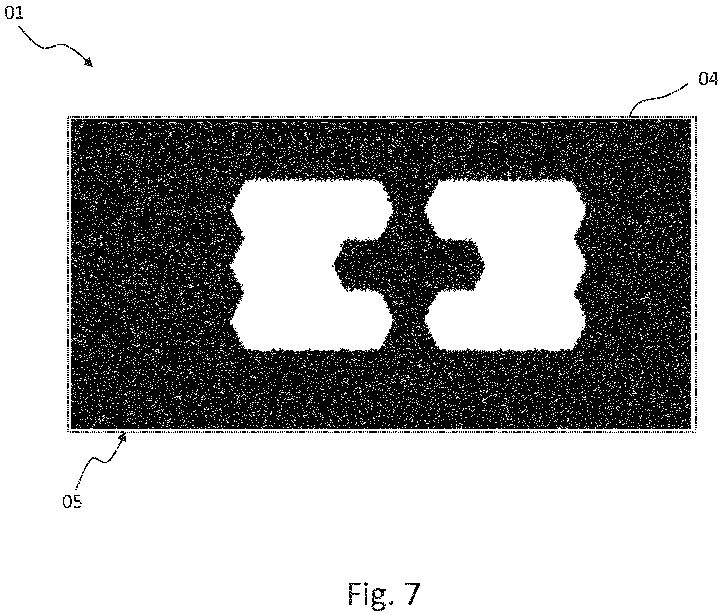

Eine in Fig. 1, Fig. 2, Fig. 3, Fig. 4, Fig. 5, Fig. 6, Fig. 7, Fig. 8, Fig. 9, Fig. 10 ganz oder in Teilen dargestelltes Leuchtmittel 01 umfasst eine durch Lichtaustrittsflächen 02 von Optikkörpern 06 von in Fig. 1 jeweils durch ein es umgebendes, gestrichelt gezeichnetes Oval hervorgehobenen Pixeln 03 eines Pixelfelds 04 gebildete Leuchtfläche 05.

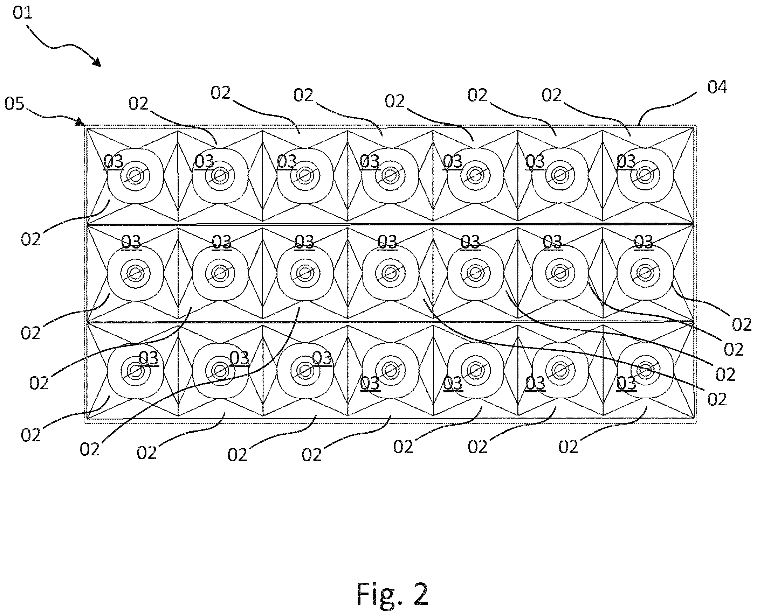

Jedes Pixel 03 des in Fig. 2, Fig. 3, Fig. 4, Fig. 5, Fig. 6, Fig. 7, Fig. 8, Fig. 9, Fig. 10 durch ein es umgebendes, gestrichelt gezeichnetes Rechteck hervorgehobenes Pixelfelds 04 umfasst einen Optikkörper 06 mit einer vorderseitigen Lichtaustrittsfläche 02 und einer rückseitigen beispielsweise eine Primäroptik 10 umfassende Lichteinkoppelfläche 07 sowie eine jeweils um die Lichteinkoppelfläche 07 und um die Lichtaustrittsfläche 02 umlaufende, die Lichteinkoppelfläche 07 und die Lichtaustrittsfläche 02 miteinander verbindende Seitenfläche 08.

Zumindest die Seitenfläche 08 eines jeden Optikkörpers 06 und damit die Seitenfläche 08 des Optikkörpers 06 jeden Pixels 03 ist beispielsweise mittels einer durch einen Metallisierungs- und/oder Bedampfungsprozess hergestellten Verspiegelung 09 verspiegelt, um ein Überkoppeln von Licht aus einem Pixel 03 in ein benachbartes zu vermeiden.

Der Lichteinkoppelfläche 07 des Optikkörpers 06 jeden Pixels 03 ist mindestens eine individuell ansteuerbare LED 11 als Lichtquelle zugeordnet, so dass jedes Pixel 03 des Pixelfelds 04 unabhängig von einem im Pixelfeld 04 benachbarten Pixel 03 ausleuchtbar ist.

Die Lichtaustrittsflächen 02 der Optikkörper 06 bilden gemeinsam die Leuchtfläche 05 des Leuchtmittels 01.

Das in Fig. 1 von einer LED 11 emittierende Licht wird wie in Fig. 1 durch Pfeile 13 dargestellt über die Primäroptik 10 des Optikkörpers 06 auf die Seitenfläche 08 des Optikkörpers 06 gelenkt. Von dort aus wird das Licht durch Total- und Reflexionseffekte zur kurz auch als Auskoppelfläche bezeichneten Lichtaustrittsfläche 02 gelenkt. Zum Teil wird Licht auch direkt von der Primäroptik 10 zur die Lichtaustrittsfläche 02 bildenden Auskoppeloberfläche gelenkt. Die Form der Lichtaustrittsfläche 02 kann dabei quadratisch, hexagonal, rund, oder auch Trapezförmig ausgeführt werden. Durch das diffuse, volumenstreuende Material erfährt das Licht auf jeden Fall weitere Streueffekte die in Summe zu einem homogenen Erscheinungsbild an der Lichtaustrittsfläche 02 und damit auch innerhalb der Leuchtfläche 05 führen.

Die an den Seitenflächen 08 und zum Teil an den Lichteinkoppelflächen 07 der Optikkörper 06 angebrachten, jeweils Verspiegelungen 09 bildenden Metallisierungsschicht verhindert ungewollten Lichtübertritt zum Nachbarelement. Die Schicht wird dabei durch ein Standardmetalisierungsverfahren aufgebracht. Die nichtbedampften Bereiche werden dabei durch Schablonen abgedeckt.

Da das Streuverhalten des volumenstreuenden Materials in der Intensität anpassbar ist, ist der Optikkörper in der Größe beispielsweise zwischen 3 mm und 20 mm Kantenlänge, insbesondere zwischen 5 mm und 20 mm Kantenlänge, skalierbar.

Bei den LEDs 11 des Leuchtmittels 01 kann es sich beispielsweise um LEDs zur Durchsteckmontage (THT; Through Hole Technology), oberflächenmontierbare (SMD; Surface Mounted Device) LEDs und LEDs handeln, bei denen der LED-Chip in Nacktmontagetechnik (COB; Chip On Board) direkt auf einen Leuchtmittelträger 12 gebondet wird.

Das Leuchtmittel 01 kann darüber hinaus den Leuchtmittelträger 12 umfassen, der vorteilhaft als Leiterbahnträger zur elektrischen Kontaktierung wenigstens der LEDs 11 ausgeführt sein kann.

Bei den in Verbindung mit einem Leuchtmittelträger 12 zum Einsatz kommenden Leiterbahnträgern handelt es sich um Leiterbahnträger, wie sie auch zur elektrischen Verschaltung von Elektronikbauteilen beispielsweise zur Ansteuerung von Leuchtmitteln mit anderen Lichtquellen als LEDs verwendet werden.

Weit verbreitetste Leiterbahnträger sind kurz als Leiterkarte, Platine oder gedruckte Schaltung (printed circuit board, PCB) bezeichnete, starre Leiterplatten.

Eine Leiterplatte ist ein Träger für elektronische Bauteile. Sie dient der mechanischen Befestigung und elektrischen Verbindung. Nahezu jedes elektronische Gerät enthält eine oder mehrere Leiterplatten.

Eine weitere Möglichkeit zur mechanischen Befestigung und elektrischen Verbindung elektronischer Bauteile stellen in MID-Technik (MID-Technik: Molded-Interconnect-Device-Technik) hergestellte spritzgegossene Schaltungsträger dar. Hierbei werden mit den elektrischen Anschlüssen eines elektronischen Bauteils beispielsweise durch Oberflächenmontagetechnik, Durchsteckmontagetechnik oder durch Draht- oder ACF-Bonding zu kontaktierende Leiterbahnen in ein Spritzgussteil, welches gleichzeitig als Träger des einen oder der mehreren elektronischen Bauteile dient, im Spritzgussprozess integriert.

Zum Betrieb von LEDs 11 als Lichtquellen für ein Leuchtmittel 01 beispielsweise einer Fahrzeugleuchte können eine oder mehrere mehr oder minder komplexe elektronische Steuerschaltungen vorgesehen sein, die beispielsweise auf einem oder mehreren Leuchtmittelträgern des Leuchtmittels angeordnet und in dem Leuchteninnenraum beherbergt sein können.

Beispiele hierfür sind elektronische Steuerschaltungen:
- zur Regelung und/oder Steuerung der Helligkeit bzw. Leuchtkraft der LEDs, beispielsweise durch eine pulsweitenmodulierte Taktung der Stromversorgung für einen außerhalb des für das menschliche Auge wahrnehmbaren Bereichs gepulsten Betrieb,
- zur Kompensation oder Vermeidung elektromagnetischer Störungen, beispielsweise aufgebaut aus Kondensatoren und/oder Ferriten,
- zum Schutz der LEDs 11 z.B. vor einer Überspannung des Bordnetzes oder vor fehlerhafter Polung, beispielsweise umfassend eine oder mehrere Zenerdioden.

Zusammengefasst muss für fast alle LED-Anwendungen eine mehr oder minder umfangreiche, für die speziellen LEDs 11 ausgelegte elektronische Steuerschaltung z.B. auf den mindestens einen Leuchtmittelträger 12 aufgebracht werden. Die elektronische Steuerschaltung umfasst im einfachsten Fall einen Vorwiderstand und eine Schutzdiode, kann aber je nach Anwendung auch wesentlich mehr Elektronikbauteile enthalten, wie z.B. Mikrokontroller bzw. Kontroller, Komparatoren, Transistoren, Schutzdioden, elektrische Widerstände z.B. als Vorwiderstand, Kondensatoren, Ferrite, etc.

Somit kann ein Leuchtmittel 01 mit mehreren LEDs 11 als Lichtquellen zusätzlich zu einer oder mehreren aufgrund ihres Diodenaufbaus Elektronikbauteile darstellenden LEDs 11 zumindest ein weiteres zuvor genanntes Elektronikbauteil umfassen. Demnach kann ein Leuchtmittel 01 mit mehreren LEDs 11 als Lichtquellen neben den LEDs 11 zumindest noch über ein weiteres Elektronikbauteil verfügen.

Die LEDs 11 und wenigstens ein weiteres Elektronikbauteil können auf einem gemeinsamen, einen Leiterbahnträger darstellenden Leuchtmittelträger 12, oder auf räumlich getrennten, untereinander beispielsweise durch einen Kabelbaum oder einen oder mehrere Teile eines Kabelbaums elektrisch verbundenen Leiterbahnträgern, von denen wenigstens einer den Leuchtmittelträger 12 bildet, angeordnet sein.

Der Leuchtmittelträger 12 kann ferner mit Befestigungspins 14 zur Anordnung des Leuchtmittelträgers 12 und mit diesem des gesamten Leuchtmittels 01 ganz oder teilweise in einem Leuchteninnenraum beispielsweise einer Fahrzeugleuchte versehen sein.

Die in einer Draufsicht auf das Pixelfeld 04 die einzelnen Pixel 03 bildenden Lichtaustrittsflächen 02 der Optikkörper 06 weisen in der Draufsicht bevorzugt eine maximale Abmessung, beispielsweise bei einer in der Draufsicht rechteckigen, insbesondere quadratischen Geometrie eine Kantenlänge, oder beispielsweise bei einer in der Draufsicht eher runden, insbesondere kreisrunden, oder mehreckigen, insbesondere hexagonalen Geometrie einen Durchmesser, von 3 mm bis 20 mm, besonders bevorzugt von 5 mm bis 16 mm, auf.

Die Pixel 03 können in einer Draufsicht auf die durch die Lichtaustrittsflächen 02 der Optikkörper 06 der Pixel 03 gebildete Leuchtfläche 05 orthogonal zueinander, oder genestet angeordnet sein.

Ein Beispiel einer orthogonalen Anordnung ist in Fig. 2 dargestellt. Dabei verlaufen die Zeilen und Spalten in jeder Zeile und in jeder Spalte orthogonal zueinander.

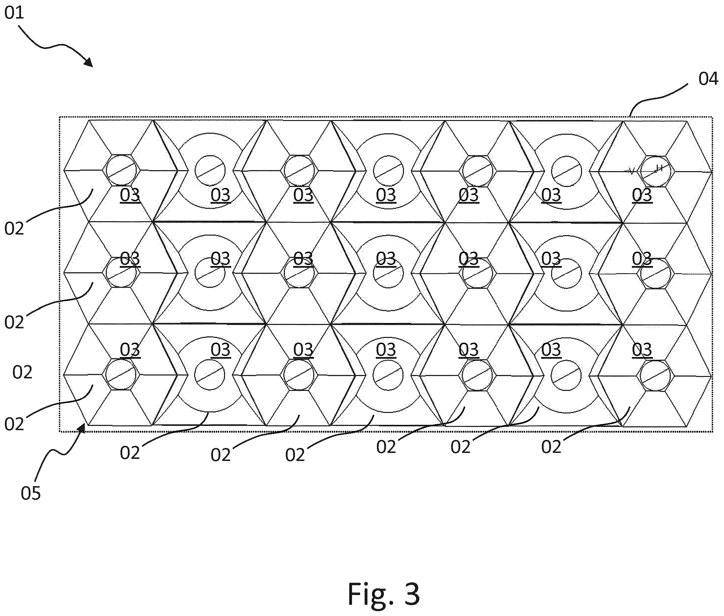

Das in Fig. 3 dargestellte Pixelfeld 04 weist eine ebenfalls orthogonale Anordnung seiner in insgesamt drei Zeilen und sieben Spalten angeordneten Pixel 03 auf, wobei diese innerhalb der Zeilen abwechselnd konvex-konkav ineinander übergehen. Innerhalb der Spalten liegen sie plan aneinander. Demnach umfasst das Pixelfeld 04 in Fig. 3 eine Kombination aus mehreckiger Geometrie, sowie orthogonaler und genesteter Anordnung der Pixel 03.

Die einzelnen Pixel 03 können in der Draufsicht auf die durch das Pixelfeld 04 gebildete Leuchtfläche 05 eine rechteckige, insbesondere quadratische Geometrie aufweisen und/oder sechseckig, insbesondere hexagonal, und/oder rund ausgeführt sein. Alternativ oder zusätzlich können sie zeilen- beziehungsweise reihenweise und/oder spaltenweise konvex-konkav ineinander übergehen. Ferner sind beispielsweise konvex-konkav ineinander übergehende Kombinationen verschiedener Geometrien der Lichtaustrittsflächen 02 der Optikkörper 06 der Pixel 03 innerhalb des Pixelfelds 04 denkbar, wie dies durch die Kombination in Fig. 3 bereits angedeutet ist.

Die Optikkörper 06 bestehen aus einem volumenstreuenden Material, um ein besonders homogenes Erscheinungsbild der Leuchtfläche 05 zu gewährleisten.

Besonders vorteilhaft grenzen die Lichtaustrittsflächen 02 der Optikkörper 06 benachbarter Pixel 03 unmittelbar aneinander an.

Ein zuvor beschriebenes Leuchtmittel 01 kann in einem von einem Leuchtengehäuse und einer zumindest für im für das menschliche Auge sichtbaren Teil des elektromagnetischen Spektrums liegendes Licht transparenten Lichtscheibe zumindest teilweise umschlossenen Leuchteninnenraum einer Fahrzeugleuchte beherbergt sein.

Die Leuchtfläche 05 des Leuchtmittels 01 ist dabei beim Blick von außerhalb des Leuchteninnenraums durch die Lichtscheibe hindurch sichtbar.

Das Leuchtengehäuse bzw. der Leuchteninnenraum kann in mehrere Kammern mit jeweils eigenen Lichtquellen und/oder Leuchtmitteln und/oder der Lichtverteilung dienenden und/oder beitragenden optischen Elementen sowie gegebenenfalls Lichtscheiben unterteilt sein, von denen mehrere Kammern gleiche und/oder jede Kammer eine andere Lichtfunktionen erfüllen kann.

Die Fahrzeugleuchte kann einzelne oder eine Kombination der zuvor und/oder noch nachfolgend in Verbindung mit dem Leuchtmittel 01 beschriebene Merkmale aufweisen, ebenso wie das Leuchtmittel 01 einzelne oder eine Kombination mehrerer zuvor und/oder noch nachfolgend in Verbindung mit der Fahrzeugleuchte beschriebene Merkmale aufweisen und/oder verwirklichen kann.

Die Fahrzeugleuchte und/oder das Leuchtmittel 01 können alternativ oder zusätzlich einzelne oder eine Kombination mehrerer einleitend in Verbindung mit dem Stand der Technik und/oder in einem oder mehreren der zum Stand der Technik erwähnten Dokumente und/oder in der voranstehenden oder noch nachfolgenden Beschreibung zu den in den Zeichnungen dargestellten Ausführungsbeispielen beschriebene Merkmale aufweisen.

Wichtig ist hervorzuheben, dass die Erfindung verwirklicht sein kann durch ein Pixelfeld 04 aus makroskopischen Pixeln 03, von denen jedes durch einen Optikkörper 06 gebildet ist, der einer LED 11 vorgesetzt ist. Die Seitenflächen 08 sowie gegebenenfalls weitere Teilflächen der Optikkörper 06 sind mit einer Verspiegelung 09 versehen, um ein Übersprechen zwischen benachbarten Pixeln 03 zu vermeiden.

Die Erfindung umfasst demnach eine Leuchtfläche 05 eines zur Erfüllung einer oder mehrerer Lichtfunktionen einer Fahrzeugleuchte vorgesehenen oder zumindest beitragenden Leuchtmittels 01, die aus den kurz als Auskoppelflächen bezeichneten Lichtaustrittsflächen 02 der Optikkörper 06 eines Felds und/oder einer Vielzahl skalierbarer makroskopischer Pixel 03 mit durch die Verspiegelung 09 zumindest der Seitenflächen 08 der Optikkörper 06 der einzelnen Pixel 03 des Pixelfelds 04 erzeugter, integrierter Lichtabschottung gebildet ist.

Die Optikkörper 06 der Pixel 03 des Pixelfelds 04 sind hierbei makroskopisch mit maximalen Abmessungen ihrer jeweiligen Lichtaustrittsfläche 02 in der Draufsicht auf das Pixelfeld 04 von vorzugsweise 3 mm bis 20 mm, besonders bevorzugt zwischen 5 mm und 16 mm ausgeführt. Bei der Maximalen Abmessung kann es sich beispielsweise um eine Kantenlänge der Lichtaustrittsfläche 02 eines Optikkörpers 06 eines Pixels 03 handeln.

Die Pixel 03 des Pixelfelds 04 sind außerdem skalierbar in ihren maximalen Abmessungen der Lichtaustrittsflächen 02 ihrer Optikkörper 06 in der Draufsicht auf das Pixelfeld 04 gesehen.

Die Pixel 03 der Pixelfelds 04 sind ferner mit einer Lichtabschottung zum Nachbarpixel mit einer Dickenabmessung im Nanometerbereich versehen. Dies kann beispielsweise vermittels einer durch Metallisierung und/oder Bedampfung hergestellte Verspiegelung 09 der Seitenflächen 09 der Optikkörper 06 der Pixel 03 des Pixelfelds 04 verwirklicht sein.

Ein jedes nachfolgend auch Optikkörper oder Optikelement genanntes Pixel 03 wird dabei durch eine konventionelle LED 11 als Lichtquelle betrieben. Dies ermöglicht je nach gewählter Lichtemissionsleistung der verwendeten LEDs 11 nicht nur die Verwirklichung von Schlusslichtfunktionen, sondern auch die Verwirklichung lichtintensiverer Lichtfunktionen wie beispielsweise einer Bremslichtfunktion und/oder einer beispielsweise durch eine Wiederholblinklichtfunktion gebildeten Fahrtrichtungsanzeige.

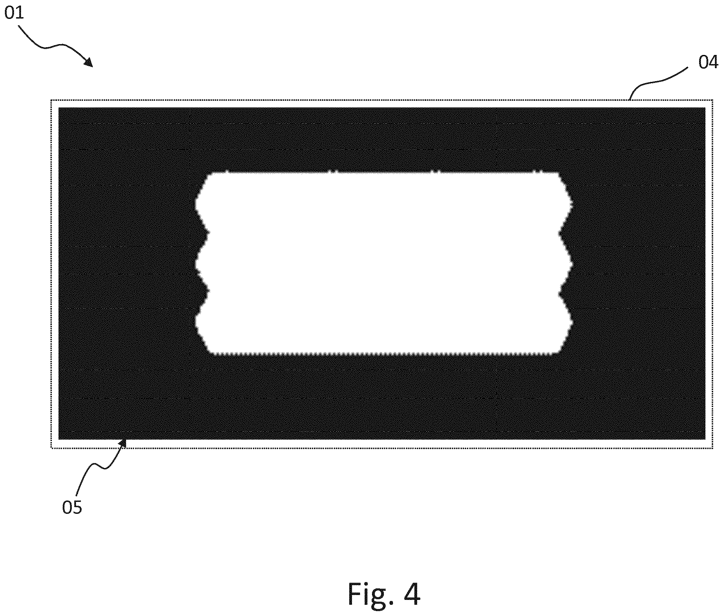

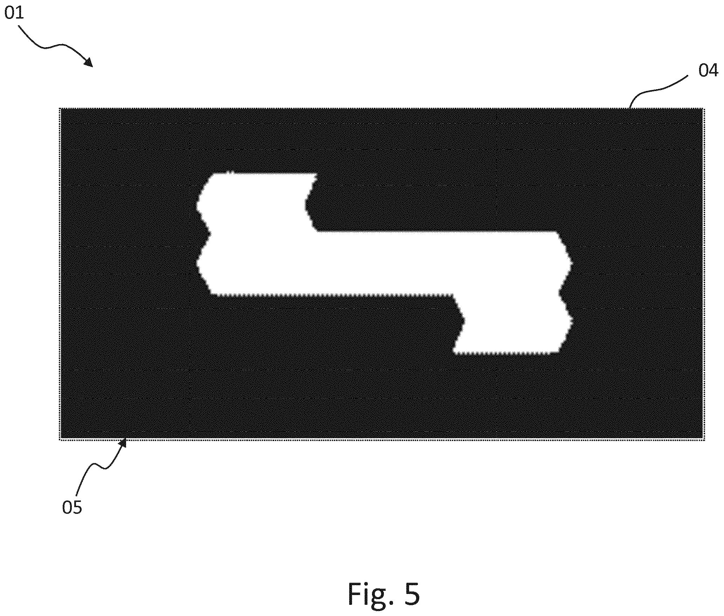

Ein über die um mehrere Größenordnungen stärkere Lichtabstrahlung hinausgehender Vorteil gegenüber dem Stand der Technik ist dabei die quasi nicht sichtbare Lichtabschottung zwischen den Pixeln 03. Dies ermöglicht sowohl homogen leuchtende Flächenbereiche mit mehreren aktiven Pixeln 03 als auch scharf abgegrenzte, geometrische Formen zu nicht aktiven Pixeln 03, wie dies in Fig. 5, Fig. 6, Fig. 7, Fig. 8, Fig. 9, Fig. 10 im Vergleich zu einem in Fig. 4 dargestellten Zustand, in dem alle Pixel 03 eines Pixelfelds 04 Licht abstrahlen, dargestellt ist. Dies führt zu einem präzisen und hochwertigen und gut erkenn- und/oder lesbaren Erscheinungsbild, da ein ungewolltes Glimmen oder Mitleuchten von Nachbarpixeln vermieden wird.

Dadurch, dass für das Pixelfeld 04 nur Standardmaterialien, wie etwa volumenstreuender Kunststoff für die bevorzugt in Spritzgusstechnik hergestellten Optikkörper 06, standard Lichtquellen, wie etwa LEDs, 11 und Standardprozesse, wie etwa einer Metallisierung von Kunststoffoberflächen zur Erzeugung der Lichtabschottung zwischen den Nachbarpixeln, verwendet werden, wird eine kostengünstige Umsetzung erhalten.

Zusätzliche, über die vollständige Lösung der gestellten Aufgabe und/oder über die voran zu den einzelnen Merkmalen genannten Vorteile hinausgehende Vorteile gegenüber dem Stand der Technik sind ebenfalls nachfolgend aufgeführt.

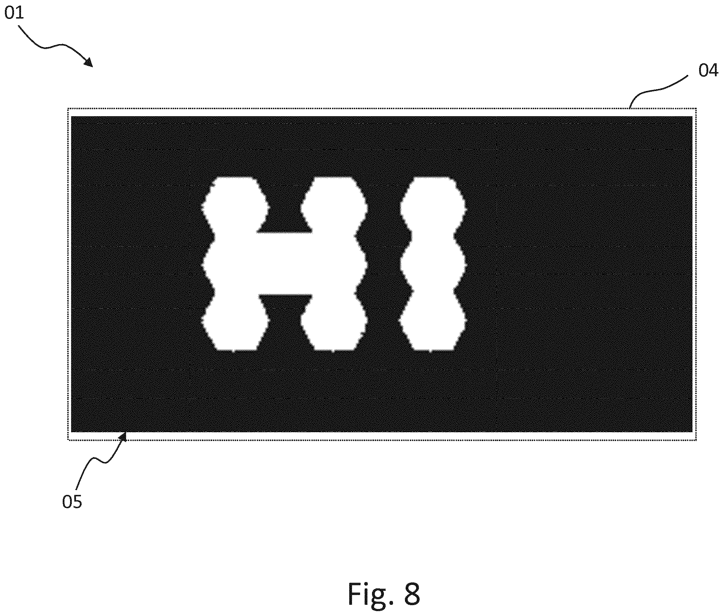

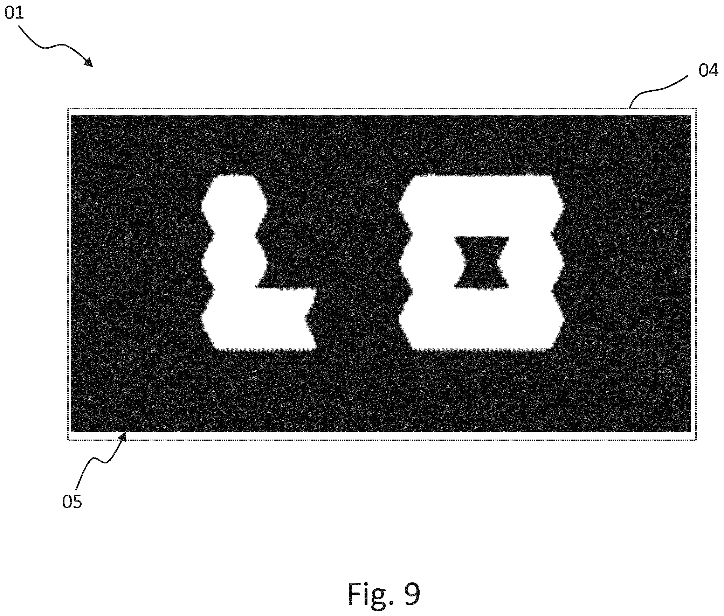

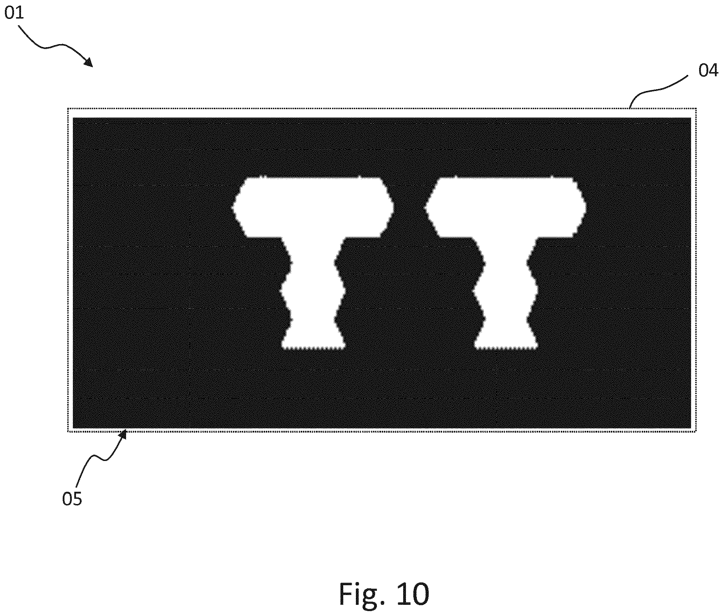

Skalierbarkeit: Kleinere Kantenlänge erhöhen die Auflösung, insbesondere für Anwendungsfälle wie etwa Hinweissymbole, Buchstaben, Schriftzüge, anmierbare Logos (Fig. 4, Fig. 5, Fig. 6, Fig. 7, Fig. 8. Fig. 9, Fig. 10). Größere Kantenlänge verringern die Ansteuerungskosten, insbesondere für Anwendungsfälle mit mehreren Funktions-Signaturen (Fig. 8, Fig. 9, Fig. 10). Auch die Anzahl der Pixel 03 des Pixelfelds 04 ist skalierbar und nur Abhängig vom verfügbaren Bauraum und der Ansteuerung.

Homogenität: Durch die Verwendung von diffusem und volumenstreuendem Material ist eine gute Homogenität der lichtabstrahlenden Lichtaustrittsflächen und damit der gesamten Leuchtfläche 05 erzielbar. Da dieses Material auch oft als Streuscheibe bei bestehenden Funktionskonzepten Verwendung findet, ist ein kombinierter Einsatz möglich, ohne dass signifikante Unterschiede im Erscheinungsbild auftreten.

Bi-Funktion: Durch Verwendung von Leistungsstärkeren LEDs können alle Pixel 03 des Pixelfelds oder auch nur Teilbereiche davon zur Verwirklichung einer Bremslichtfunktion oder beispielsweise einer Wiederholblinklichtfunktion zur Fahrtrichtungsanzeige betrieben werden. Auch der Betrieb mit Multi-Color LEDs ist möglich, so dass zum Beispiel Schlusslichtfunktion-Fahrtrichtungsanzeige Kombinationen mit roter und gelber Lichtfarbe für die verschiedenen Lichtfunktionen umsetzbar sind.

Im Vergleich zu Display- und OLED- Lösungen setzt die Erfindung auf bewährte Materialien und Prozesse.

Das Leuchtmittel 01 und einer hiermit ausgestattete Fahrzeugleuchte können alternativ oder zusätzlich zur Erfüllung einer oder mehrerer Lichtfunktionen von außerhalb der Fahrzeugleuchte erkennbare Zusatzinformationen bereitstellen, wie beispielsweise in Fig. 8, Fig. 9, Fig. 10 gezeigt.

Aktuell wird im Zuge der Umweltdiskussionen - wie etwa über Feinstaub - auch verstärkt über die Kennbarmachung der unterschiedlichen Antriebssysteme wie z.B. Diesel, Benzin, Wasserstoff, Gas, Elektro, etc. gesprochen.

Dies kann beispielsweise durch spezielle, von außerhalb der Fahrzeugleuchte erkennbare Zusatzinformationen kommuniziert werden. So kann beispielsweise eine Lichtsignatur wie in Fig. 9 verwendet werden, um einen besonders emissionsarmen Betrieb (LO wie LOW EMISSION) von außerhalb kenntlich zu machen. Im Gegenzug kann auch der Betrieb eines Verbrennungsmotors mit fossilen Brennstoffen durch eine in Fig. 8 gezeigte Lichtsignatur (HI wie HIGH EMISSION) nach außerhalb angezeigt werden.

Davon abgesehen, wollen die Nutzer beispielsweise von Elektrofahrzeugen ihr Umweltbewusstsein auch gerne nach außen tragen, im Sinne von "Ich mache was für die Umwelt!".

Alternativ können solche Lichtsignaturen auch dazu benutzt werden, einem Nutzer beispielsweise eines Elektrofahrzeugs bevor dieser in das Elektrofahrzeug einsteigt, und/oder wenn dieser wieder aus dem Elektrofahrzeug ausgestiegen ist, den aktuellen Ladezustand (Fig. 8: HI wie HIGH; Fig. 9: LO wie LOW) seines Stromspeichers anzuzeigen.

Ferner sind weitere Lichtsignaturen, wie etwa die in Fig. 5, Fig. 6, Fig. 7, Fig. 10 dargestellten Lichtsignaturen denkbar, mit denen Benutzer von Fahrzeugen deren Erscheinung beispielsweise bei Annäherung an das Fahrzeug individualisieren können.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Ansprüchen beinhaltet, auch wenn dieses Merkmal oder diese Kombination selbst nicht explizit in den Ansprüchen oder Ausführungsbeispielen angegeben ist.

Die Erfindung ist insbesondere im Bereich der Herstellung von Fahrzeugleuchten, insbesondere Kraftfahrzeugleuchten gewerblich anwendbar.

Die Erfindung wurde unter Bezugnahme auf bevorzugte Ausführungsformen beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

### Bezugszeichenliste

- 01: Leuchtmittel
- 02: Lichtaustrittsfläche
- 03: Pixel
- 04: Pixelfeld
- 05: Leuchtfläche
- 06: Optikkörper
- 07: Lichteinkoppelfläche
- 08: Seitenfläche
- 09: Verspiegelung
- 10: Primäroptik
- 11: LED
- 12: Leuchtmittelträger
- 13: Pfeil
- 14: Befestigungspin

## Patentansprüche

1. Fahrzeugleuchte mit einem von einem Leuchtengehäuse und einer Lichtscheibe zumindest teilweise umschlossenen Leuchteninnenraum, der ein Leuchtmittel (01) mit einer durch ein Pixelfeld (04) gebildeten Leuchtfläche (05) beherbergt, wobei:
- jedes Pixel (03) des Pixelfelds (04) einen Optikkörper (06) mit einer vorderseitigen Lichtaustrittsfläche (02) und einer rückseitigen Lichteinkoppelfläche (07) sowie einer die Lichteinkoppelfläche (07) und die Lichtaustrittsfläche (02) miteinander verbindenden Seitenfläche (08) umfasst,
- zumindest die Seitenfläche (08) des Optikkörpers (06) jeden Pixels (03) verspiegelt ist,
- der Lichteinkoppelfläche (02) des Optikkörpers jeden Pixels mindestens eine individuell ansteuerbare LED (11) als Lichtquelle zugeordnet ist, und
- die Optikkörper (06) aus einem volumenstreuenden Material bestehen.

2. Fahrzeugleuchte nach Anspruch 1, wobei die in einer Draufsicht auf das Pixelfeld (04) die einzelnen Pixel (03) bildenden Lichtaustrittsflächen (02) der Optikkörper (06) eine maximale Abmessung von 3 mm bis 20 mm, bevorzugt von 5 mm bis 16 mm, aufweisen.

3. Fahrzeugleuchte nach Anspruch 1 oder 2, wobei die Pixel (03) in einer Draufsicht orthogonal zueinander, oder genestet angeordnet sind.

4. Fahrzeugleuchte nach einem der Ansprüche 1, 2 oder 3, wobei die einzelnen Pixel (03) eine rechteckige, insbesondere quadratische Geometrie aufweisen und/oder sechseckig und/oder rund ausgeführt sind und/oder konvex-konkav ineinander übergehen.

5. Fahrzeugleuchte nach einem der voranstehenden Ansprüche, wobei die Lichtaustrittsflächen (02) der Optikkörper (06) benachbarter Pixel (03) unmittelbar aneinander angrenzen.

## Claims

1. A vehicle lamp with a lamp interior, which is at least partially enclosed by a lamp housing and a light lens, and which accommodates a lighting means (01) with a luminous surface (05) formed by a pixel field (04), wherein:
- each pixel (03) of the pixel field (04) comprises an optical body (06) with a light emitting surface (02) at the front and a light incoupling surface (07) at the back, as well as a side surface (08) connecting the light incoupling surface (07) and the light emitting surface (02) to each other,
- at least the side surface (08) of the optical body (06) of each pixel (03) is mirrored,
- at least one individually controllable LED (11) is assigned as a light source to the light incoupling surface (07) of the optical body of each pixel, and
- the optical bodies (06) consist of a volume scattering material.

2. The vehicle lamp according to claim 1, wherein the light emitting surfaces (02) of the optical bodies (06) forming the individual pixels (03), as seen in a top view of the pixel field (04), have a maximum dimension of 3 mm to 20 mm, preferably of 5 mm to 16 mm.

3. The vehicle lamp according to claim 1 or 2, wherein the pixels (03) are arranged orthogonally to each other or in a nested manner, as seen in a top view.

4. The vehicle lamp according to one of the claims 1, 2, or 3, wherein the individual pixels (03) have a rectangular, in particular, a square geometry and/or are designed to be hexagonal and/or round and/or merge into each other in a convex-concave manner.

5. The vehicle lamp according to one of the previous claims, wherein the light emitting surfaces (02) of the optical bodies (06) of adjacent pixels (03) are immediately next to each other.

## Revendications

1. Lampe de véhicule comprenant un volume intérieur de lampe qui est entouré au moins en partie d'un boîtier de lampe et d'une glace et qui loge un moyen lumineux (01) ayant une surface lumineuse (05) formée par un champ de pixels (04), dans laquelle:
- chaque pixel (03) du champ de pixels (04) comprend un corps optique (06) ayant une surface avant de sortie de lumière (02) et une surface arrière de couplage de lumière (07) ainsi qu'une surface latérale (08) reliant la surface de couplage de lumière (07) et la surface de sortie de lumière (02),
- au moins la surface latérale (08) du corps optique (06) de chaque pixel (03) est traitée pour être réfléchissante,
- au moins une DEL (11) qui peut être commandée individuellement est associée, en tant que source de lumière, à la surface de couplage de lumière (07) du corps optique de chaque pixel, et
- les corps optiques (06) sont constitués d'un matériau à dispersion de volume.

2. Lampe de véhicule selon la revendication 1, dans laquelle les surfaces de sortie de lumière (02) des corps optiques (06), qui forment les pixels individuels (03) dans une vue de dessus sur le champ de pixels (04) présentent une dimension maximale comprise entre 3 mm et 20 mm, de préférence entre 5 mm et 16 mm.

3. Lampe de véhicule selon la revendication 1 ou 2, dans laquelle, vus dans une vue de dessus, les pixels (03) sont disposés orthogonalement les uns aux autres ou de manière imbriquée.

4. Lampe de véhicule selon l'une quelconque des revendications 1, 2 ou 3, dans laquelle les pixels individuels (03) présentent une géométrie rectangulaire, en particulier carrée et/ou sont hexagonaux et/ou ronds et/ou se confondent de manière convexe-concave.

5. Lampe de véhicule selon l'une quelconque des revendications précédentes, dans laquelle les surfaces de sortie de lumière (02) des corps optiques (06) de pixels (03) adjacents sont directement contiguës les unes aux autres.
